# EUROPÄISCHE PATENTSCHRIFT

(11) **EP 3 315 008 B1**
(45) Veröffentlichungstag und Bekanntmachung des Hinweises auf die Patenterteilung: **28.04.2021**
(21) Anmeldenummer: 17197923.0
(22) Anmeldetag: 24.10.2017
(51) Int. Cl.: A01D 43/10, A01D 82/02, B02C 4/08, B02C 4/30

(54) **FÖRDER- UND AUFBEREITUNGSWALZE FÜR EINE ERNTEMASCHINE**
CONVEYOR AND PROCESSING ROLLER FOR A HARVESTER
ROULEAU DE TRANSPORT ET ROULEAU CONDITIONNEUR POUR UNE RÉCOLTEUSE

(30) Priorität: 28.10.2016 AT 509912016
(43) Veröffentlichungstag der Anmeldung: 02.05.2018
(73) Patentinhaber: Gebrüder Busatis Gesellschaft m.b.H., 3251 Purgstall an der Erlauf (AT)
(72) Erfinder: Lutz, Wolfgang, 3250 Wieselburg (AT); Nadlinger, Markus, 3324 Euratsfeld (AT)
(74) Vertreter: Puchberger & Partner Patentanwälte

(56) Entgegenhaltungen:
- EP-A1- 0 995 352
- EP-A1- 2 940 169
- WO-A1-2015/075157
- US-A1- 2007 266 689
- US-A1- 2010 043 371
- US-A1- 2014 166 797

## Beschreibung

Die Erfindung betrifft eine Förder- und Aufbereitungswalze für eine Erntemaschine mit an ihrer Oberfläche vorgesehenen Zahnkanten aufweisenden Zähnen, wobei die Walze zumindest im Bereich der Zahnkanten und/oder Zahnflanken ihrer Zähne eine durchgehende oder in Teilzonen aufgeteilte Verschleißschutzzone aufweist, deren Verschleißwiderstand größer ist als der des Materials des Grundkörpers der Förder- und Aufbereitungswalze. Die Erfindung betrifft ferner ein Verfahren zum Herstellen einer Förder- und Aufbereitungswalze für eine Erntemaschine mit an ihrer Oberfläche vorgesehenen Zahnkanten aufweisenden Zähnen. Weiters betrifft die Erfindung die Anordnung von zwei derartigen Walzen.

Bei Erntemaschinen für Mais und Ganzpflanzen sowohl als Futtermittel als auch für Biogasanlagen wird das Erntegut nach dem Schneiden und Häckseln durch eine Vorrichtung mit Förder- und Aufbereitungswalzen geführt, die ein Aufbrechen der Körner bewirkt und damit den Aufschluss des Ernteguts erlaubt. Gleichzeitig dient die Vorrichtung zur Förderung des Ernteguts. Bei diesen Vorrichtungen wird das gehäckselte Erntegut einem Paar zylindrischer Förder- und Aufbereitungswalzen mit an ihrer Oberfläche vorgesehenen Zähnen, deren Zahnkanten parallel oder schräg zur Längsachse der Förder- und Aufbereitungswalze verlaufen, zugeführt. Die beiden Walzen rotieren gegenläufig, wobei eine der Walzen eine höhere Rotationsgeschwindigkeit, z.B. um 20% erhöht, hat. Um sowohl die Funktion des Aufbrechens der Körner als auch die Funktion der Förderung des Erntegutes gut erfüllen zu können, muss der Abstand zwischen den im Reibspalt einander gegenüberliegenden Zahnkanten der beiden Förder- und Aufbereitungswalzen über die gesamte Länge und in jeder beliebigen Winkelstellung der Walzen zueinander in einem engen vorgegebenen Bereich, z.B. für Mais zwischen 0,5 und 3 mm, liegen.

Solche Förder- und Aufbereitungswalzen sind aus WO 2015/075157 A1 bekannt.

Durch die Förder- und Aufbereitungsarbeit tritt an den Zahnkanten ein Verschleiß auf, der zu einer Abrundung der Zahnkanten führt. Dadurch vergrößert sich der Abstand zwischen den Zahnkanten im Spalt der beiden Walzen und die Funktion des Aufbrechens der Körner geht verloren. Zwar kann der Abstand der beiden parallelen Drehachsen der Walzen verstellbar sein, aber eine Nachjustierung ist oft nicht möglich, da über die Länge der Walzen gesehen der Verschleiß unterschiedlich sein kann. So entsteht z.B. ein größerer Verschleiß an den beiden Walzenenden, wenn dort mehr Material durchgeführt wird. Der maximale Verschleiß entscheidet dann über den Austausch der ganzen Walze. Ökonomische Reparaturverfahren für Förder- und Aufbereitungswalzen sind bisher nicht bekannt.

Zur Verringerung des Verschleißes ist es derzeit bekannt, bei Förder- und Aufbereitungswalzen im Bereich der Zahnkanten z.B. durch induktives Härten den Verschleißwiderstand zu erhöhen. Ferner gibt es am Markt hartverchromte, nitrierte oder borierte Förder- und Aufbereitungswalzen, die den Nachteil einer kontinuierlichen Abrundung der Zahnkanten aufweisen. Auch die Fertigung der Förder- und Aufbereitungswalzen aus verschleißfesterem Material wie Hartguss ist möglich. Alle diese Verfahren sind einerseits sehr teuer und andererseits sind die Standzeiten aber nach wie vor unzureichend.

Aufgabe der vorliegenden Erfindung ist es, eine Förder- und Aufbereitungswalze und deren Anordnung zu schaffen, mit deren Einsatz wirtschaftlicher gearbeitet werden kann, d.h. deren Herstellung kostengünstiger ist und/oder deren Standzeit noch höher ist, und ein Verfahren zur Herstellung dieser Förder- und Aufbereitungswalze zu finden.

Dazu ist eine erfindungsgemäße Förder- und Aufbereitungswalze gemäß Anspruch 1 und ein Verfahren zu deren Herstellung gemäß Anspruch 13 vorgesehen. Hochenergiestrahlverfahren zeichnen sich durch eine hohe Energiedichte aus, sodass bei der Herstellung der Verschleißschutzzone eine kurze Einwirkzeit des Hochenergiestrahls genügt und das Material des Grundkörpers nur an der Oberfläche bzw. in sehr oberflächennahen Bereichen bis etwa 1 mm beeinflusst wird. Insbesondere kommt es durch das Hochenergiestrahlverfahren bei einem vorgehärteten Material des Grundkörpers im Bereich der Wärmeeinflusszone nur zu einem geringen Härteabfall. Ist das Material des Grundkörpers nicht gehärtet, kommt es durch die geringe Eindringtiefe zur raschen Abkühlung und damit zu einer Aufhärtung des Materials des Grundkörpers und damit zu einer Stützwirkung für die Verschleißschutzzone. Hochenergiestrahlverfahren sind in der Literatur ausreichend beschrieben. Beispielsweise sei auf DE 10 2007 059 865 A1, DE 196 49 865 C1 und EP 2 476 864 A1 verwiesen.

Durch das Hochenergiestrahlverfahren wird eine Verschleißschutzzone hergestellt, die zu einer beachtlichen Standzeitverlängerung führt, wobei die Form der Zähne durch das Hochenergiestrahlverfahren im Wesentlichen nicht mehr verändert wird. Durch diese endkonturnahe Bearbeitung ist ein guter Erhalt der Zahnkanten möglich und eine Nachbearbeitung nicht erforderlich.

In der vorliegenden Beschreibung bezeichnet der Ausdruck "Verschleißschutzzone" einerseits die gegen Verschleiß geschützten Bereiche jedes einzelnen Zahnes als Zahnverschleißschutzzone und zum anderen die dadurch gebildeten Bereiche der Walze als Walzenverschleißschutzzonen. Mit "Zähne" werden die Zahnstege bezeichnet, die etwa in Längsrichtung der Zylinderfläche der Walzen ausgerichtet sind. Diese können auch schräg oder leicht gekurvt gegenüber einer achsparallelen Anordnung angeordnet sein.

Vorteilhafterweise hat die Verschleißschutzzone einen Verschleißwiderstand, der um mindestens 10% größer und vorzugsweise um mindestens 25% größer als der Verschleißwiderstand des Materials des Grundkörpers ist. Der Verschleißwiderstand bzw. die abrasive Verschleißbeständigkeit lässt sich dabei z.B. über das Reibradverfahren nach der Norm ASTM G65 bestimmen.

Die Verschleißschutzzone kann durch Gefügeumwandlung des Materials des Grundkörpers in einem Härtungsverfahren oder Umschmelzverfahren mittels Hochenergiestrahl hergestellt sein. In diesen Verfahren wird das Material des Grundkörpers selbst im oberflächennahen Bereich durch den Hochenergiestrahl ohne Zusatzwerkstoff verändert und damit der Verschleißwiderstand gesteigert.

Alternativ kann die Verschleißschutzzone durch ein Beschichtungs-, Auftragsschweiß-, Dispergier-, Legierungs- oder Einschmelzverfahren mittels Hochenergiestrahl hergestellt sein. Durch diese Verfahren wird ein Zusatzwerkstoff auf bzw. in die Oberfläche des Grundkörpers auf- bzw. eingebracht.

Da bei Hochenergiestrahlverfahren der Energieeintrag in das Material des Grundkörper nur in sehr oberflächennahe Bereiche bis etwa 1 mm erfolgt und die gegebenenfalls aufgetragene Materialdicke sehr gering, nämlich 0,05 bis maximal 0,5 mm, bevorzugt 0,1 bis 0,4 mm, besonders bevorzugt 0,2 bis 0,3 mm ist, kommt es zu keiner wesentlichen Veränderung der Form der Zähne.

Die Verschleißschutzzone kann erfindungsgemäß Hartstoffteilchen enthalten. Durch kantige Hartstoffteilchen kann, insbesondere bei großen Hartstoffteilchen, eine raue Oberfläche erzielt werden, die für ein gutes Erfassen des Ernteguts beim Aufbrechen und eine gute Förderwirkung auf den Erntegutstrom sorgt.

Vorzugsweise ist die Verschleißschutzzone eine durch ein Auftragsschweißverfahren aufgebrachte Hartstoffbeschichtung. Die Ausbildung der rauen Oberfläche wird noch dadurch begünstigt, dass die Hartstoffteilchen durch den raschen Erstarrungsprozess aus dem Matrixmaterial herausragen.

Dabei enthält die durch ein Auftragsschweißverfahren aufgebrachte Hartstoffbeschichtung in vorteilhafter Weise in ein Matrixmaterial eingebettete Hartstoffpartikel mit einer Größe zwischen 40 und 250 µm, wobei das Matrixmaterial vorzugsweise Nickel, Kobalt oder eine Nickel-Chrom-Silizium-Verbindung enthält und die Hartstoffpartikel vorzugsweise Karbide, Nitride oder Oxide, besonders bevorzugt Wolframkarbide sind.

Ist die Verschleißschutzzone nur in einem der Zahnkante beim Förder- und Aufbereitungsvorgang nacheilenden Bereich vorgesehen, ist einerseits weniger Beschichtungsmaterial erforderlich, wodurch kostengünstiger produziert werden kann, und andererseits ergibt sich durch Verschleiß des Materials des Grundkörpers in den voreilenden Bereichen an der Zahnkante ein Selbstschärfeeffekt.

Der Grundkörper kann zumindest im Bereich der Zähne, insbesondere durch Randschichthärten, besonders bevorzugt durch induktives Härten, vorgehärtet oder nachträglich gehärtet sein.

Bei dem erfindungsgemäßen Verfahren kann das Gefüge des Materials des Grundkörpers ohne Zusatzwerkstoff in einem Härtungs- oder Umschmelzverfahren umgewandelt werden.

Alternativ wird mittels Beschichtungs-, Auftragsschweiß-, Dispergier-, Legierungs- oder Einschmelzverfahren ein Zusatzwerkstoff in bzw. auf den Grundkörper ein- bzw. aufgebracht. Dabei kann z.B. in einem Auftragsschweißverfahren der Grundkörper mittels Hochenergiestrahl mit einer Hartstoffbeschichtung beschichtet werden.

Erfindungsgemäß erfolgt eine paarweise Anordnung der beschriebenen Förder- und Aufbereitungswalzen, wobei die paarweise Anordnung von Förder- und Aufbereitungswalzen gemäß einer oder mehrerer der vorhergehenden Ansprüche zur Förderung und Aufbereitung von Erntegut, wie Mais, Getreide, Hirse, dadurch gekennzeichnet, dass die beiden Walzen gegenläufig rotierend angetrieben sind und zwischen ihnen ein das Aufbrechen des Ernteguts erlaubenden Spalts vorgesehen ist, und dass die beiden Walzen eine unterschiedliche Drehgeschwindigkeit aufweisen. Bevorzugt weisen die Walzen Walzenverschleißschutzzonen auf, die in einander entgegengesetzter Richtung spiralförmig die Walzen umgeben.

Weitere vorteilhafte Merkmale sind den Ansprüchen und der nachfolgenden Beschreibung und den Zeichnungen zu entnehmen.

Um die Erfindung besser zu verdeutlichen, wird sie anhand der beiliegenden Zeichnungen nochmals erläutert.
Fig. 1 zeigt schematisch zwei Förder- und Aufbereitungswalzen, durch die das Erntegut hindurchgeführt wird.
Figuren 2a bis 2c zeigen schematisch je einen Teilquerschnitt durch eine Förder- und Aufbereitungswalze mit verschieden ausgeformten Verschleißschutzzonen an den Zähnen.
Figuren 3, 4 und 5 zeigen jeweils zwei Förder- und Aufbereitungswalzen in einer perspektivischen Ansicht.

Durch die zwei Förder- und Aufbereitungswalzen 1 wird das Erntegut 6 hindurchgeführt und aufbereitet.

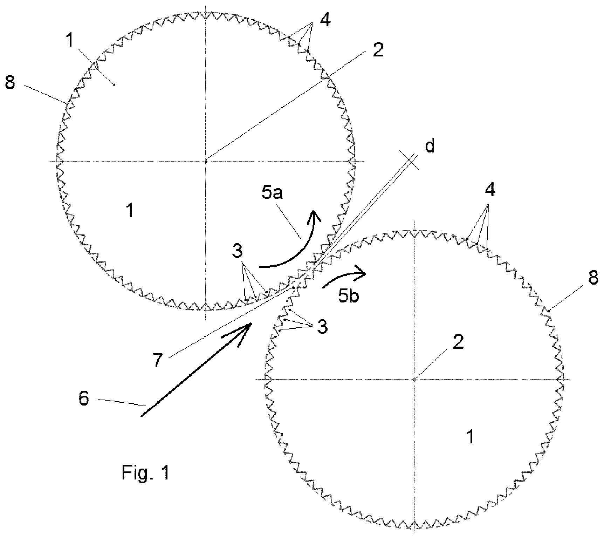

Die in Fig. 1 gezeigten Förder- und Aufbereitungswalzen 1 haben gleichen Durchmesser, der üblicherweise bei 150 bis 350 mm liegt. Die Länge der Förder- und Aufbereitungswalzen 1 liegt üblicherweise bei 500 bis 1000 mm. Die Drehachsen 2 der beiden Förder- und Aufbereitungswalzen 1 verlaufen parallel. Auf der Mantelfläche weist jede Förder- und Aufbereitungswalze 1 Zähne 3 auf, deren Zahnkanten 4 parallel oder schräg zur Längs- und Drehachse 2 der Förder- und Aufbereitungswalze 1 verlaufen. Die Zähne 3 können im Querschnitt gleichschenkelig oder sägezahnförmig sein. Die Walzen 1 rotieren gegenläufig, wobei eine der Walzen 1, in der Figur 1 die obere, mit einer größeren Rotationsgeschwindigkeit rotiert, wie dies durch den längeren Pfeil 5a im Vergleich zu Pfeil 5b angedeutet ist. Das Erntegut 6 wird durch den Reibspalt 7 zwischen den Walzen 1 geführt, wobei die Zähne 3 der Walzen 1 sowohl für den Transport des Ernteguts 6 als auch für das Aufbrechen der Körner im Erntegut 6 sorgen.

Wie man in Fig. 1 sieht, besteht zwischen den Umhüllenden 8 der beiden Walzen 1, die durch die Zahnkanten 4 der Walzen 1 verlaufen, ein Abstand d, der etwas kleiner als die Korngröße des Ernteguts 6 sein sollte, aber dennoch nicht so klein sein darf, dass ein Stau des Ernteguts 6 verursacht wird. Für Mais z.B. sollte der Abstand d zwischen 2 und 3 mm liegen. Für kleinere Körner von Ganzpflanzen muss der Abstand d entsprechend kleiner sein, um das Aufbrechen der Körner sicherzustellen. Der im Betrieb auftretende Verschleiß rundet die Zahnkanten 4 ab. Bereits eine Vergrößerung des Abstands d um nur einen Millimeter führt sogar dazu, auch wenn es nur in Teillängsabschnitten der Walzen 1 so ist, dass ein Teil der Körner nicht aufgebrochen wird und die Qualität des Futtermittels/Grundstoffs sinkt. Es ist daher essentiell, den Abstand d im optimalen Bereich zu halten. Bei gleichmäßigem Verschleiß über die Länge der Walzen 1 kann durch Änderung des Abstandes der Drehachsen 2 der beiden Förder- und Aufbereitungswalzen 1 eine Nachjustierung des Abstands d erfolgen, allerdings dürfen die Zahnkanten 4 auch nicht zu stumpf sein und in den meisten Fällen werden im Betrieb die Zähne 3 der Förder- und Aufbereitungswalzen 1 über die Länge auch unterschiedlich beansprucht, wodurch es bei Förder- und Aufbereitungswalzen 1 des Standes der Technik zu unterschiedlich starkem Verschleiß über die Länge der Walzen 1 kommt.

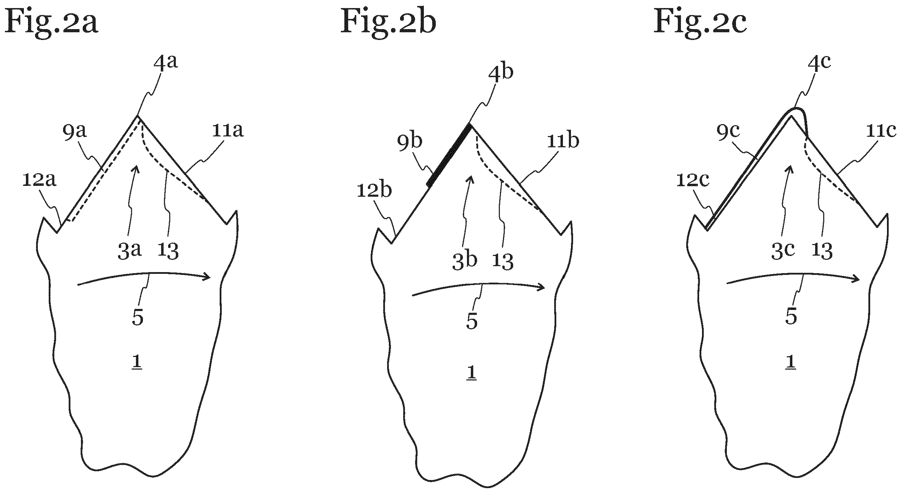

Die Figuren 2a, 2b und 2c illustrieren an drei Zähnen 3a, 3b und 3c verschiedene Zahnverschleißschutzzonen 9a, 9b und 9c an den Zähnen, die durch verschiedene Hochenergiestrahlverfahren hergestellt wurden. Die Zähne 3a, 3b und 3c haben im gezeigten Beispiel die Form eines gleichschenkligen Dreiecks mit den in Drehrichtung 5 voreilenden Flanken 11a, 11b, 11c und nacheilenden Flanken 12a, 12b, 12c. Die Zähne 3a, 3b und 3c können im Querschnitt auch sägezahnförmig sein. Der Grundkörper der Förder- und Aufbereitungswalze 1 ist ein Zylinder mit den Zähnen 3 an seinem Umfang und sowohl Zylinder als auch Zähne 3 bestehen aus Material des Grundkörpers. Der Grundkörper kann beispielsweise gegossen oder geschmiedet sein und erhält vorzugsweise seine endgültige Form durch mechanische Bearbeitung. Erfindungsgemäß werden durch ein Hochenergiestrahlverfahren an der Oberfläche der Zähne 3a, 3b und 3c zumindest im Bereich ihrer Zahnkanten 4a, 4b, 4c Verschleißschutzzonen 9a, 9b, 9c der Zähne hergestellt. Dabei ändert sich die Geometrie der Zahnstruktur der Zähne 3a, 3b und 3c nicht oder nur unwesentlich. Beim Zahn 3a ist schematisch eine Verschleißschutzzone 9a des Zahnes 3a, die ohne Zusatzwerkstoff hergestellt wurde, dargestellt. Dabei wurde in der obersten Schicht der nacheilenden Flanke 12a des Zahns 3a das Material des Grundkörpers verändert, z.B. durch ein Härtungs- oder ein Umschmelzverfahren.

Bei den Zähnen 3b und 3c hingegen erfolgte die Herstellung der Verschleißschutzzonen 9b, 9c an den Zähnen 3b, 3c durch Aufbringung eines Zusatzwerkstoffs mittels Hochenergiestrahlverfahren. Dabei zeigt der Zahn 3b eine Verschleißschutzzone 9b auf der nacheilenden Flanke 12b, entlang der Zahnkante 4b. Der Zahn 3c zeigt eine Verschleißschutzzone 9c in Form einer Beschichtung, die sich hauptsächlich über die nacheilende Flanke 12c des Zahns 3c erstreckt und die Zahnkante 4c übergreift. Tragen die Zähne 3a, 3b und 3c die Verschleißschutzzone 9a, 9b und 9c nur oder hauptsächlich auf der nacheilenden Flanke, kommt es auf der voreilenden Flanke 11a, 11b und 11c ohne Verschleißschutzzone zu einem rascheren Verschleiß aufgrund des geringeren Verschleißwiderstandes des Materials des Grundkörpers im Vergleich zum Verschleißwiderstand der Verschleißschutzzone 9a, 9b und 9c und es ergibt sich ein Selbstschärfeeffekt 13.

Bevorzugt werden die Walzen nur eine der Varianten der mit einer Verschleißschutzzone versehenen Zähne aufweisen. Es sind aber auch beliebige Variationen an einer Walze möglich. Wie gesagt, können die Zähne auch sägezahnförmig ausgebildet sein.

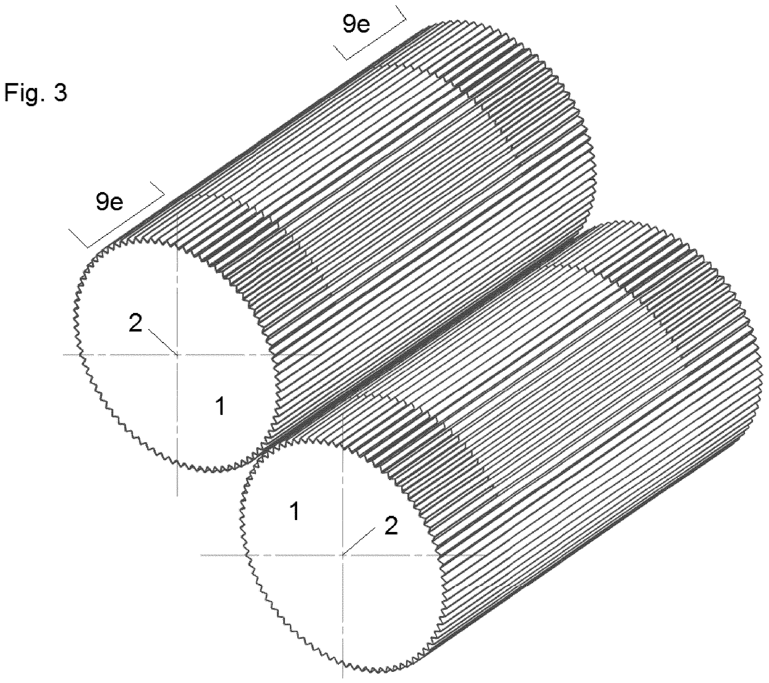

Fig. 3 zeigt zwei Förder- und Aufbereitungswalzen 1 mit partiellen und/oder verstärkten Walzenverschleißschutzzonen 9e an den Enden der Walzen 1, die mit Zähnen mit den Zahnverschleißschutzzonen 9a, 9b und 9c in Fig. 2, versehen sein können. Der üblicherweise an den Enden der Förder- und Aufbereitungswalzen 1 höheren Beanspruchung kann mit einer erfindungsgemäßen verstärkten Ausbildung von Verschleißschutzzonen 9e an den Enden der Walzen 1 entgegengetreten werden, wie dies in Fig. 3 angedeutet ist. Somit verschleißen die am stärksten beanspruchten Abschnitte der Walzen 1 langsamer, der Abstand d zwischen den Walzen 1 bleibt konstant und die Standzeit der Walzen 1 wird erhöht.

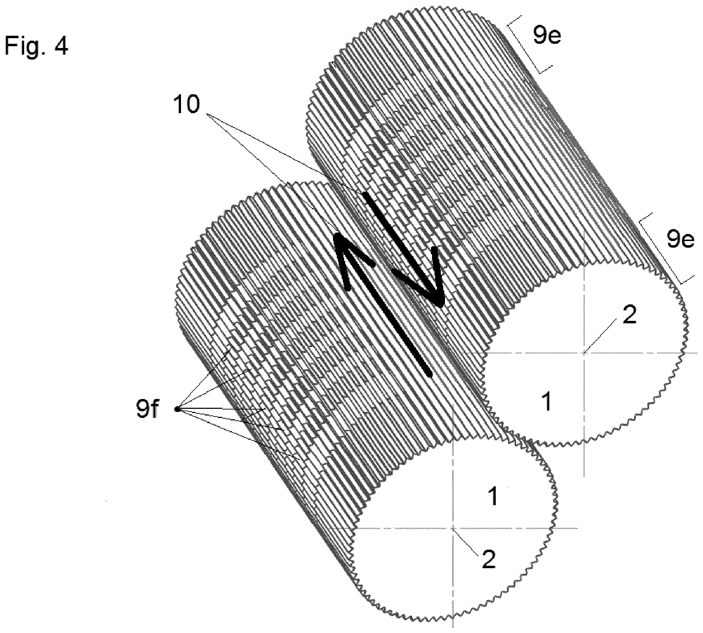

Fig. 4 zeigt ebenfalls zwei Förder- und Aufbereitungswalzen 1, wo die Verschleißschutzzonen 9e an den Walzenenden wie in Fig. 4 bzw. Fig. 2 ausgebildet sind und zusätzlich zwischen diesen eine spiralförmige und/oder verstärkte Walzenverschleißschutzzone 9f aufgebracht wird. Durch die spiralförmige Verschleißschutzzone 9f der gegenläufigen Walzen 1 oder die Verstärkung dieser Zone 9f entsteht ein geringfügiger Höhenunterschied an den Zahnkanten 4, der eine axiale Scherwirkung 10 verursacht und den Aufbereitungsgrad des Ernteguts 6 verbessert.

Die Verschleißschutzzonen 9 an den Zähnen 3 sind generell durch Hochenergiestrahlverfahren hergestellt und zwar entweder ohne Einbringung von Zusatzwerkstoffen in einem Härtungs- oder Umschmelzverfahren, oder mit Ein- oder Aufbringung von Zusatzwerkstoffen in einem Beschichtungs-, Auftragsschweiß-, Dispergier-, Legierungs- oder Einschmelzverfahren. Insbesondere kann die Verschleißschutzzone 9 durch eine Hartstoffbeschichtung verwirklicht sein und z.B. in ein Matrixmaterial eingebettete Hartstoffpartikel mit einer Größe zwischen 40 und 250 µm enthalten, wobei das Matrixmaterial vorzugsweise Nickel, Kobalt oder eine Nickel-Chrom-Silizium-Verbindung enthält und die Hartstoffpartikel vorzugsweise Karbide, Nitride oder Oxide, besonders bevorzugt Wolframkarbide sind.

Alternativ zur beschriebenen Härtung oder Hartstoffbeschichtung der nacheilenden Zahnflanken 12 kann es auch vorteilhaft sein, die voreilenden Zahnflanken 11 ebenfalls zu härten oder hart zu beschichten, allerdings mit geringerem Verschleißwiderstand als die nacheilenden Flanken 12, um den selbstschärfenden Effekt zu erreichen.

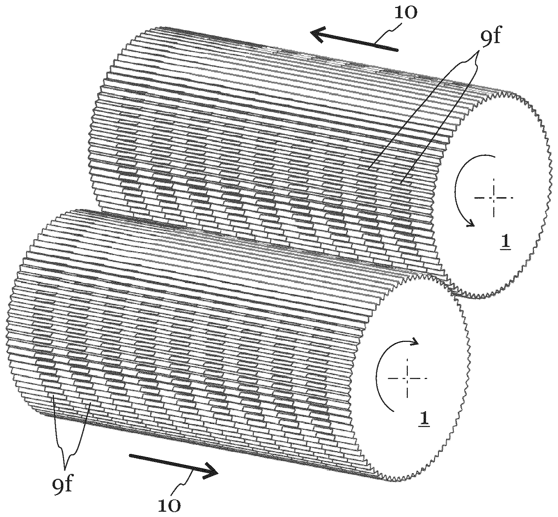

Die Fig. 5 zeigt eine Walzenanordnung, bei der die Walzenverschleißschutzzonen 9f jeweils spiralförmig den Zylindermantel der Walzen umgeben. Durch den stärkeren Verschleiß der nicht gehärteten Zonen zwischen den Walzenverschleißschutzzonen kommt es zu einer Scherwirkung auf das Erntegut, welches dadurch gut aufgebrochen und gleichmäßig über die Walzen verteilt wird.

### Bezugszeichenliste

| | | | |
|---|---|---|---|
| 1 | Aufbereitungswalze | | |
| 2 | Drehachsen | | |
| 3 | Zähne | | |
| 4 | Zahnkanten | | |
| 5a | Pfeil (länger) | 5b | Pfeil (kürzer) |
| 6 | Erntegut | | |
| 7 | Reibspalt | | |
| 8 | Umhüllende | | |
| 9 | Verschleißschutzzone | | |
| 10 | Scherwirkung | | |
| 11 | Voreilende Flanken | | |
| 12 | Nacheilende Flanken | | |
| 13 | Selbstschärfeeffekt | | |
| d | Abstand | | |

## Patentansprüche

1. Förder- und Aufbereitungswalze (1) für eine Erntemaschine für Mais und Ganzpflanzen zum Aufschluss des Ernteguts nach dem Schneiden und Häckseln, wobei die Walze an ihrer Oberfläche mit Zähnen (3) in Form von Zahnleisten versehen ist, die sich über die Längserstreckung der Walze erstrecken und jeweils eine voreilende (11a, 11b, 11c) und eine nacheilende (12a, 12b, 12c) Zahnflanke sowie eine Zahnkante (4a, 4b, 4c) aufweisen, und wobei die Walze (1) durchgehend oder in Teilbereichen mit Verschleißschutzzonen versehen ist, deren Verschleißwiderstand größer ist als der des Materials des Grundkörpers der Walze (1), wobei der Grundkörper eine die Form der Zähne (3) bestimmende Zahnstruktur hat, **dadurch gekennzeichnet, dass** an der Oberfläche der Zahnleisten (3a, 3b, 3c) zumindest im Bereich der Zahnkanten (4a, 4b, 4c) durch Hochenergiestrahlverfahren Verschleißschutzzonen (9) vorgesehen sind, die sich hauptsächlich über die nacheilenden Flanken (12a, 12b, 12c) bei voreilenden Flanken (11a, 11b, 11c) ohne Verschleißschutzzone (9) erstrecken.

2. Förder- und Aufbereitungswalze (1) nach Anspruch 1, **dadurch gekennzeichnet, dass** der Verschleißwiderstand der Verschleißschutzzone (9) um mindestens 10% größer und vorzugsweise um mindestens 25% größer als der Verschleißwiderstand des Materials des Grundkörpers ist.

3. Förder- und Aufbereitungswalze (1) nach einem der Ansprüche 1 oder 2, **dadurch gekennzeichnet, dass** die Verschleißschutzzone (9) durch Gefügeumwandlung des Materials des Grundkörpers ohne Zusatzwerkstoff in einem Härtungs- oder Umschmelzverfahren hergestellt ist.

4. Förder- und Aufbereitungswalze (1) nach einem der Ansprüche 1 oder 2, **dadurch gekennzeichnet, dass** die Verschleißschutzzone (9) durch Auf- oder Einbringen eines Zusatzwerkstoffes mittels Beschichtungs-, Auftragsschweiß-, Dispergier-, Legierungs- oder Einschmelzverfahren hergestellt ist.

5. Förder- und Aufbereitungswalze (1) nach Anspruch 4, **dadurch gekennzeichnet, dass** die Verschleißschutzzone (9) Hartstoffteilchen aufweist.

6. Förder- und Aufbereitungswalze (1) nach einem der Ansprüche 1, 2, 4 oder 5 **dadurch gekennzeichnet, dass** die Verschleißschutzzone (9) eine durch ein Auftragsschweißverfahren aufgebrachte Hartstoffbeschichtung ist.

7. Förder- und Aufbereitungswalze (1) nach Anspruch 6, **dadurch gekennzeichnet, dass** die durch ein Auftragsschweißverfahren aufgebrachte Hartstoffbeschichtung eine Dicke von 0,05 bis 0,5 mm, bevorzugt von 0,1 bis 0,4 mm, besonders bevorzugt von 0,2 bis 0,3 mm hat.

8. Förder- und Aufbereitungswalze (1) nach Anspruch 6 oder 7, **dadurch gekennzeichnet, dass** die durch ein Auftragsschweißverfahren aufgebrachte Hartstoffbeschichtung in ein Matrixmaterial eingebettete Hartstoffteilchen mit einer Größe zwischen 40 und 250 µm enthält, wobei das Matrixmaterial vorzugsweise Nickel, Kobalt oder eine Nickel-Chrom-Silizium-Verbindung enthält und die Hartstoffpartikel vorzugsweise Karbide, Nitride oder Oxide, besonders bevorzugt Wolframkarbide, sind.

9. Förder- und Aufbereitungswalze (1) nach Anspruch 8, **dadurch gekennzeichnet, dass** die Hartstoffteilchen aus dem rasch erstarrten Matrixmaterial herausragend und eine raue Oberfläche bildend angeordnet sind.

10. Förder- und Aufbereitungswalze (1) nach einem der vorhergehenden Ansprüche, **dadurch gekennzeichnet, dass** der Grundkörper zumindest im Bereich der Zähne (3), insbesondere durch Randschichthärten, besonders bevorzugt durch induktives Härten, vorgehärtet oder nachträglich gehärtet ist.

11. Förder- und Aufbereitungswalze (1) nach einem der vorhergehenden Ansprüche, **dadurch gekennzeichnet, dass** auf den Grundkörper die Verschleißschutzzonen (9e, 9f) alternativ auf folgende Bereiche aufgebracht werden:
a. über die gesamte Walzenoberfläche oder
b. nur im Bereich des höchsten Verschleißes, bevorzugt an den Walzenenden, oder
c. über die gesamte Walzenoberfläche und zusätzlich in den Bereichen des höchsten Verschleißes, bevorzugt an den Walzenenden, in verstärkter Ausführung, oder
d. über die gesamte Walzenoberfläche und zusätzlich in den Bereichen des höchsten Verschleißes, bevorzugt an den Walzenenden und/oder einem spiralförmigen Bereich zwischen diesen, in verstärkter Ausführung, oder
e. spiralförmig über die gesamte Walzenoberfläche.

12. Förder- und Aufbereitungswalze (1) nach einem der vorhergehenden Ansprüche, **dadurch gekennzeichnet, dass** die Verschleißschutzbeschichtung die Zahnkante (4c) übergreifend angeordnet ist.

13. Verfahren zum Herstellen einer Förder- und Aufbereitungswalze (1) für eine Erntemaschine für Mais und Ganzpflanzen zum Aufschluss des Ernteguts nach dem Schneiden und Häckseln mit an ihrer Oberfläche vorgesehenen Zahnkanten (4) aufweisenden Zähnen (3), wobei die Walze (1) zumindest im Bereich der Zahnkanten (4) und/oder Zahnflanken ihrer Zähne (3) eine durchgehende oder in Teilzonen aufgeteilte Verschleißschutzzone (9) aufweist, deren Verschleißwiderstand größer ist, als der des Materials des Grundkörpers der Förder- und Aufbereitungswalze (1), **dadurch gekennzeichnet, dass** der Grundkörper mit einer die Form der Zähne (3) bestimmenden Zahnstruktur hergestellt wird und dann durch ein Hochenergiestrahlverfahren der Grundkörper unter im Wesentlichen Beibehaltung der Geometrie der Zahnstruktur mit der Verschleißschutzzone (9) versehen wird, die sich hauptsächlich über die nacheilende Flanke (12a, 12b, 12c) bei vorauseilender Flanke (11a, 11b, 11c) ohne Verschleißschutzzone (9) erstreckt.

14. Paarweise Anordnung von Förder- und Aufbereitungswalzen (1) gemäß einem der Ansprüche 1 bis 12 zur Förderung und Aufbereitung von Erntegut (6), wie Mais, Getreide, Hirse, **dadurch gekennzeichnet, dass** die beiden Walzen (1) gegenläufig rotierend angetrieben sind und zwischen ihnen ein das Aufbrechen des Ernteguts (6) erlaubender Spalt (d) vorgesehen ist, und dass die beiden Walzen (1) eine unterschiedliche Drehgeschwindigkeit aufweisen.

15. Anordnung nach Anspruch 14, **dadurch gekennzeichnet, dass** die Walzen (1) Verschleißschutzzonen (9f) aufweisen, die in einander entgegengesetzter Richtung spiralförmig die Walzen (1) umgeben.

## Claims

1. A conveying and conditioning roller (1) for a harvester for maize and whole plants for breaking up the harvested crop after cutting and chopping, the roller being provided with teeth (3) in the form of toothed strips, which extend over the longitudinal extension of the roller and each have a leading (11a, 11b, 11c) and a trailing (12a, 12b, 12c) tooth flank and a tooth edge (4a, 4b, 4c), on its surface and wherein the roller (1) is continuously or partially provided with wear protection zones, the wear resistance of which is greater than that of the material of the base body of the roller (1), the base body having a tooth structure which determines the shape of the teeth (3), **characterized in that** on the surface of the toothed strips (3a, 3b, 3c), at least in the region of the tooth edges (4a, 4b, 4c), wear protection zones (9) are provided by high-energy blasting method, which zones extend mainly over the trailing flanks (12a, 12b, 12c) in the case of leading flanks (11a, 11b, 11c) without a wear protection zone (9).

2. The conveying and conditioning roller (1) according to claim 1, **characterized in that** the wear resistance of the wear protection zone (9) is at least 10 % greater and preferably at least 25 % greater than the wear resistance of the material of the base body.

3. The conveying and conditioning roller (1) according to one of claims 1 or 2, **characterized in that** the wear protection zone (9) is produced by microstructural transformation of the material of the base body without filler material in a hardening or remelting process.

4. The conveying and conditioning roller (1) according to one of claims 1 or 2, **characterized in that** the wear protection zone (9) is produced by applying or introducing a filler material by means of a coating, build-up welding, dispersion, alloying or melt-in process.

5. The conveying and conditioning roller (1) according to claim 4, **characterized in that** the wear protection zone (9) comprises hard material particles.

6. The conveying and conditioning roller (1) according to one of claims 1, 2, 4 or 5, **characterized in that** the wear protection zone (9) is a hard material coating applied by a build-up welding process.

7. The conveying and conditioning roller (1) according to claim 6, **characterized in that** the hard material coating applied by a build-up welding process has a thickness of 0.05 to 0.5 mm, preferably of 0.1 to 0.4 mm, particularly preferably of 0.2 to 0.3 mm.

8. The conveying and conditioning roller (1) according to claim 6 or 7, **characterized in that** the hard material coating applied by a build-up welding process contains hard material particles embedded in a matrix material with a size between 40 and 250 µm, wherein the matrix material preferably contains nickel, cobalt or a nickel-chromium-silicon compound and the hard material particles are preferably carbides, nitrides or oxides, particularly preferably tungsten carbides.

9. The conveying and conditioning roller (1) according to claim 8, **characterized in that** the hard material particles are arranged protruding from the rapidly solidified matrix material and forming a rough surface.

10. The conveying and conditioning roller (1) according to one of the preceding claims, **characterized in that** the base body is prehardened or subsequently hardened at least in the region of the teeth (3), in particular by surface hardening, especially preferably by inductive hardening.

11. The conveying and conditioning roller (1) according to one of the preceding claims, **characterized in that** the wear protection zones (9e, 9f) are applied to the base body alternatively on the following areas:
a. over the entire roller surface, or
b. only in the area of highest wear, preferably at the roller ends, or
c. over the entire roller surface and additionally in the areas of highest wear, preferably at the roller ends, in a reinforced design, or
d. over the entire roller surface and additionally in the areas of highest wear, preferably at the roller ends and/or a spiral-shaped area between them, in a reinforced design, or
e. spirally over the entire roller surface.

12. The conveying and conditioning roller (1) according to one of the preceding claims, **characterized in that** the wear protection coating is arranged overlapping the tooth edge (4c).

13. A method for producing a conveying and conditioning roller (1) for a harvesting machine for maize and whole plants for breaking up the harvested crop after cutting and chopping, with teeth (3) having tooth edges (4) provided on their surface, the roller (1) having, at least in the region of the tooth edges (4) and/or tooth flanks of its teeth (3), a continuous wear protection zone (9) or a wear protection zone (9) divided into partial zones, the wear resistance of which is greater than that of the material of the base body of the conveying and conditioning roller (1), **characterized in that** the base body is produced with a tooth structure determining the shape of the teeth (3) and then, by means of a high-energy blasting method, the base body is provided with the wear protection zone (9) while substantially retaining the geometry of the tooth structure, which wear protection zone (9) extends mainly over the trailing flank (12a, 12b, 12c) in the case of a leading flank (11a, 11b, 11c) without a wear protection zone (9).

14. An arrangement in pairs of conveying and conditioning rollers (1) according to one of claims 1 to 12 for conveying and conditioning harvested crop (6), such as maize, grain, millet, **characterized in that** the two rollers (1) are driven to rotate in opposite directions and a gap (d) is provided between them which allows the harvested crop (6) to be broken up, and **in that** the two rollers (1) have a different rotational speed.

15. The arrangement according to claim 14, **characterized in that** the rollers (1) have wear protection zones (9f) which surround the rollers (1) in a spiral in opposite directions.

## Revendications

1. Rouleau de transport et de traitement (1) pour une récolteuse de maïs et de plantes entières, destiné à briser la récolte après la coupe et le hachage, le rouleau étant muni sur sa surface de dents (3) sous forme de bandes dentées qui s'étendent sur l'étendue longitudinale du rouleau et qui présentent chacune un flanc de dent avançant (11a, 11b, 11c) et un flanc de dent suiveur (12a, 12b, 12c) ainsi qu'une arête de dent (4a, 4b, 4c), et le rouleau (1) étant pourvu sur toute sa longueur ou dans des zones partielles de zones de protection contre l'usure dont la résistance à l'usure est supérieure à celle du matériau du corps de base du rouleau (1), le corps de base présentant une structure de dent qui détermine la forme des dents (3), **caractérisé en ce que** sur la surface des bandes dentées (3a, 3b, 3c), au moins dans la région des arêtes de dent (4a, 4b, 4c), des zones de protection contre l'usure (9) sont prévues par le sablage à haute énergie et s'étendent principalement sur les flancs suiveurs (12a, 12b, 12c) dans le cas des flancs avançants (11a, 11b, 11c) sans zone de protection contre l'usure (9).

2. Rouleau de transport et de traitement (1) selon la revendication 1, **caractérisé en ce que** la résistance à l'usure de la zone de protection contre l'usure (9) est supérieure d'au moins 10 %, et de préférence d'au moins 25 %, à la résistance à l'usure du matériau du corps de base.

3. Rouleau de transport et de traitement (1) selon l'une des revendications 1 ou 2, **caractérisé en ce que** la zone de protection contre l'usure (9) est produite par transformation microstructurelle du matériau du corps de base sans métal d'apport dans un processus de durcissement ou de refonte.

4. Rouleau de transport et de traitement (1) selon l'une des revendications 1 ou 2, **caractérisé en ce que** la zone de protection contre l'usure (9) est produite par l'application ou l'introduction d'un métal d'apport au moyen d'un procédé de revêtement, de rechargement par soudure, de dispersion, d'alliage ou de refonte.

5. Rouleau de transport et de traitement (1) selon la revendication 4, **caractérisé en ce que** la zone de protection contre l'usure (9) comprend des particules de matériau dur.

6. Rouleau de transport et de traitement (1) selon l'une des revendications 1, 2, 4 ou 5, **caractérisé en ce que** la zone de protection contre l'usure (9) est un revêtement de matériau dur appliqué par un procédé de rechargement par soudure.

7. Rouleau de transport et de traitement (1) selon la revendication 6, **caractérisé en ce que** le revêtement de matériau dur appliqué par un procédé de rechargement par soudure a une épaisseur de 0,05 à 0,5 mm, de préférence de 0,1 à 0,4 mm, particulièrement de préférence de 0,2 à 0,3 mm.

8. Rouleau de transport et de traitement (1) selon la revendication 6 ou 7, **caractérisé en ce que** le revêtement de matériau dur appliqué par un procédé de rechargement par soudure contient des particules de matériau dur noyées dans un matériau de matrice et ayant une taille comprise entre 40 et 250 µm, le matériau de matrice contenant de préférence du nickel, du cobalt ou un composé nickel-chrome-silicium et les particules de matériau dur étant de préférence des carbures, des nitrures ou des oxydes, en particulier de préférence des carbures de tungstène.

9. Rouleau de transport et de traitement (1) selon la revendication 8, **caractérisé en ce que** les particules de matériau dur sont disposées en saillie par rapport au matériau de la matrice rapidement solidifié et forment une surface rugueuse.

10. Rouleau de transport et de traitement (1) selon l'une des revendications précédentes, **caractérisé en ce que** le corps de base est pré-trempé ou trempé ultérieurement au moins dans la zone des dents (3), en particulier par durcissement superficiel, de préférence par induction.

11. Rouleau de transport et de traitement (1) selon l'une des revendications précédentes, **caractérisé en ce que** les zones de protection contre l'usure (9e, 9f) sont appliquées sur le corps de base alternativement sur les zones suivantes :
a. sur toute la surface du rouleau, ou
b. uniquement dans la zone d'usure maximale, de préférence aux extrémités du rouleau, ou
c. sur toute la surface du rouleau et, en outre, dans les zones d'usure maximale, de préférence aux extrémités du rouleau, dans une version renforcée, ou
d. sur toute la surface du rouleau et, en outre, dans les zones d'usure maximale, de préférence aux extrémités du rouleau et/ou dans une zone en spirale entre celles-ci, dans une version renforcée, ou
e. en spirale sur toute la surface du rouleau.

12. Rouleau de transport et de traitement (1) selon l'une des revendications précédentes, **caractérisé en ce que** le revêtement de protection contre l'usure est disposé en chevauchement avec l'arête de dent (4c).

13. Procédé de fabrication d'un rouleau de transport et de traitement (1) pour une récolteuse de maïs et de plantes entières, destiné à briser la récolte après la coupe et le hachage, avec des dents (3) présentant des arêtes de dent (4) prévus sur leur surface, le rouleau (1) présentant, au moins dans la zone des arêtes de dent (4) et/ou des flancs de dent de ses dents (3), une zone de protection contre l'usure (9) continue ou divisée en zones partielles, dont la résistance à l'usure est plus élevée que celui du matériau du corps de base du rouleau de transport et de traitement (1), **caractérisé en ce que** le corps de base est fabriqué avec une structure dentée qui détermine la forme des dents (3) et ensuite, au moyen d'un procédé de sablage à haute énergie, le corps de base est pourvu de la zone de protection contre l'usure (9) tout en conservant essentiellement la géométrie de la structure dentée, laquelle zone de protection contre l'usure (9) s'étend principalement sur le flanc suiveur (12a, 12b, 12c) dans le cas d'un flanc avançant (11a, 11b, 11c) sans zone de protection contre l'usure (9).

14. Agencement par paires de rouleaux de transport et de traitement (1) selon l'une des revendications 1 à 12 pour le transport et le traitement des récoltes (6), tels que du maïs, des céréales, du millet, **caractérisé en ce que** les deux rouleaux (1) sont entraînés en rotation dans des sens opposés et qu'un espace (d) permettant de briser les produits de récolte (6) est prévu entre eux, et **en ce que** les deux rouleaux (1) ont une vitesse de rotation différente.

15. Agencement selon la revendication 14, **caractérisé en ce que** les rouleaux (1) présentent des zones de protection contre l'usure (9f) qui entourent les rouleaux (1) en spirale dans des directions opposées.
